# EUROPEAN PATENT APPLICATION

(11) **EP 4 546 977 A1**
(43) Date of publication of application: **30.04.2025**
(21) Application number: 24180455.8
(22) Date of filing: 06.06.2024
(51) Int. Cl.: H10D 84/03

(54) **SEMICONDUCTOR DEVICE INCLUDING DUAL CONTACT STRUCTURES ON SOURCE/DRAIN REGION**

(30) Priority: 27.10.2023 US 202363546114 P; 26.03.2024 US 202418617125
(71) Applicant: Samsung Electronics Co., Ltd., Suwon-si, Gyeonggi-do 16677 (KR)
(72) Inventor: LEE, Jaehong, San Jose, CA 95134 (US); KIM, Jintae, San Jose, CA 95134 (US); SEO, Kangill, San Jose, CA 95134 (US); YANG, Myung, San Jose, CA 95134 (US)
(74) Representative: Kuhnen & Wacker Patent- und Rechtsanwaltsbüro PartG mbB

(57) **Abstract**

Provided is a semiconductor device 20 which includes a 1^{st} source/drain region 135; and a 1^{st} contact structure CA11 on a 1^{st} portion of the 1^{st} source/drain region 135; and a 2^{nd} contact structure CA12 on a 2^{nd} portion of the 1^{st} source/drain region 135, wherein at least one of the 1^{st} contact structure CA11 and the 2^{nd} contact structure CA12 is configured to connect the 1^{st} source/drain region 135 to a voltage source or another circuit element for signal routing.

## Description

### BACKGROUND

### 1. Field

Apparatuses and methods consistent with the disclosure relate to a three-dimensionally-stacked (3D-stacked) semiconductor device, also referred to as a multi-stack semiconductor device, in which dual contact structures are formed on a lower source/drain region.

### 2. Description of Related Art

A 3D-stacked semiconductor device has been introduced in response to increased demand for an integrated circuit having a high device density and performance. The 3D-stacked semiconductor device may include a 1^{st} transistor at a 1^{st} level and a 2^{nd} transistor at a 2^{nd} level above the 1^{st} level, where each of the transistors may be a fin field-effect transistor (FinFET), a nanosheet transistor, a forksheet transistor, or any other type of transistor.

The FinFET has one or more horizontally arranged vertical fin structures as a channel structure of which at least three surfaces are surrounded by a gate structure, and the nanosheet transistor is characterized by one or more nanosheet layers vertically stacked on a substrate as a channel structure and a gate structure surrounding all four surfaces of each of the nanosheet layers. The nanosheet transistor is referred to as gate-all-around (GAA) transistor, or as a multi-bridge channel field-effect transistor (MBCFET). The forksheet transistor is a combination of two nanosheet transistors with an insulation backbone structure therebetween. Nanosheet layers of each nanosheet transistor are formed at each side of the insulation backbone structure and pass through a gate structure in parallel with the backbone structure.

In the 3D-stacked semiconductor device, a position of a contact structure which connects a source/drain region of the 1^{st} transistor at the 1^{st} level to a voltage source or another circuit element may affect power delivery performance or signal routing performance.

Information disclosed in this Background section has already been known to or derived by the inventors before or during the process of achieving the embodiments of the present application, or is technical information acquired in the process of achieving the embodiments. Therefore, it may contain information that does not form the prior art that is already known to the public.

### SUMMARY

According to an aspect, there is provided a semiconductor device which may include: a 1^{st} source/drain region; and a 1^{st} contact structure on a 1^{st} portion of the 1^{st} source/drain region. The semiconductor device may include a 2^{nd} contact structure on a 2^{nd} portion of the 1^{st} source/drain region. For example, at least one of the 1^{st} contact structure and the 2^{nd} contact structure is configured to connect the 1^{st} source/drain region to a voltage source or another circuit element for signal routing.

According to an aspect, the 1^{st} contact structure and the 2^{nd} contact structure may be connected to each other through a metal line in a middle-of-line (MOL) layer or a back-end-of-line (BEOL) layer.

According to an aspect, there is provided a semiconductor device which may include: a 1^{st} source/drain region for a 1^{st} transistor; and a 2^{nd} source/drain region for a 2^{nd} transistor, the 2^{nd} source/drain region being disposed vertically above the 1^{st} source/drain region. For example, the 2^{nd} source/drain region may have a smaller width than the 1^{st} source/drain region in a channel-width direction view. For example, the channel-width direction intersects a direction of current flow in each of the 1^{st} transistor and the 2^{nd} transistor. For example, a non-overlapping region, where the 2^{nd} source/drain region does not vertically overlap the 1^{st} source/drain region, is formed at each of a left side and a right side of the 2^{nd} source/drain region in the channel-width direction view.

According to an aspect, the semiconductor device is 3D-stacked. The semiconductor device may include: a 1^{st} contact structure on the 1^{st} source/drain region. For example, the 1^{st} contact structure passes through one of the non-overlapping regions; and a 2^{nd} contact structure on the 1^{st} source/drain region. For example, the 2^{nd} contact structure passes through the other of the non-overlapping regions.

According to an aspect, there is provided a semiconductor device which may include: a 1^{st} source/drain region; and a 2^{nd} source/drain region, vertically above the 1^{st} source/drain region. For example, two or more 1^{st} contact structures are formed on the 1^{st} source/drain region, and only one 2^{nd} contact structure is formed on the 2^{nd} source/drain region.

### BRIEF DESCRIPTION OF DRAWINGS

Example embodiments of the disclosure will be more clearly understood from the following detailed description taken in conjunction with the accompanying drawings.
FIGS. 1A-1C illustrate a 3D-stacked semiconductor device in which a contact structure is formed on each of a source/drain region at a 1^{st} level and a source/drain region at a 2^{nd} level, according to one or more embodiments.
FIGS. 2A-2C illustrate a 3D-stacked semiconductor device in which two contact structures are formed on a source/drain region at a 1^{st} level and a contact structure is formed on a source/drain region at a 2^{nd} level, according to one or more embodiments.
FIGS. 3A-3C illustrate a 3D-stacked semiconductor device in which only one of two contact structures of the 3D-stacked semiconductor device shown in FIGS. 2A-2C is formed on a source/drain region at a 1^{st} level and a contact structure is formed on a source/drain region at a 2^{nd} level, according to one or more embodiments.
FIGS. 4A-4C illustrate a 3D-stacked semiconductor device in which two contact structures are formed on a source/drain region at a 1^{st} level and a contact structure is formed on a source/drain region at a 2^{nd} level, according to one or more other embodiments.
FIGS. 5A-5C illustrate a 3D-stacked semiconductor device in which two contact structures are formed on a source/drain region at a 1^{st} level and a contact structure is formed on a source/drain region at a 2^{nd} level, according to one or more other embodiments.
FIG. 6 is a schematic block diagram illustrating an electronic device including a semiconductor device in which two or more contact structures are formed on a source/drain region of the semiconductor device, according to one or more embodiments.

### DETAILED DESCRIPTION

The embodiments of the disclosure described herein are example embodiments, and thus, the disclosure is not limited thereto, and may be realized in various other forms. Each of the embodiments provided in the following description is not excluded from being associated with one or more features of another example or another embodiment also provided herein or not provided herein but consistent with the disclosure. For example, even if matters described in a specific example or embodiment are not described in a different example or embodiment thereto, the matters may be understood as being related to or combined with the different example or embodiment, unless otherwise mentioned in descriptions thereof. In addition, it should be understood that all descriptions of principles, aspects, examples, and embodiments of the disclosure are intended to encompass structural and functional equivalents thereof. In addition, these equivalents should be understood as including not only currently well-known equivalents but also equivalents to be developed in the future, that is, all devices invented to perform the same functions regardless of the structures thereof. For example, channel layers, sacrificial layers, and isolation layers described herein may take a different type or form as long as the disclosure can be applied thereto.

It will be understood that when an element, component, layer, pattern, structure, region, or so on (hereinafter collectively "element") of a semiconductor device is referred to as being "over," "above," "on," "below," "under," "beneath," "connected to" or "coupled to" another element the semiconductor device, it can be directly over, above, on, below, under, beneath, connected or coupled to the other element or an intervening element(s) may be present. In contrast, when an element of a semiconductor device is referred to as being "directly over," "directly above," "directly on," "directly below," "directly under," "directly beneath," "directly connected to" or "directly coupled to" another element of the semiconductor device, there are no intervening elements present. Like numerals refer to like elements throughout this disclosure.

Spatially relative terms, such as "over," "above," "on," "upper," "below," "under," "beneath," "lower," "left," "right," "lower-left," "lower-right," "upper-left," "upper-right," "central," "middle," and the like, may be used herein for ease of description to describe one element's relationship to another element(s) as illustrated in the figures. It will be understood that the spatially relative terms are intended to encompass different orientations of a semiconductor device in use or operation in addition to the orientation depicted in the figures. For example, if the semiconductor device in the figures is turned over, an element described as "below" or "beneath" another element would then be oriented "above" the other element. Thus, the term "below" can encompass both an orientation of above and below. The semiconductor device may be otherwise oriented (rotated 90 degrees or at other orientations) and the spatially relative descriptors used herein interpreted accordingly. As another example, when elements referred to as a "left" element and a "right" element" may be a "right" element and a "left" element when a device or structure including these elements are differently oriented. Thus, in the descriptions herebelow, the "left" element and the "right" element may also be referred to as a "1^{st}" element or a "2^{nd}" element, respectively, as long as their structural relationship is clearly understood in the context of the descriptions. Similarly, the terms a "lower" element and an "upper" element may be respectively referred to as a "1^{st}" element and a "2^{nd}" element with necessary descriptions to distinguish the two elements.

It will be understood that, although the terms "1^{st}," "2^{nd}," "3^{rd}," "4^{th}," "5^{th}," "6^{th}," etc. may be used herein to describe various elements, these elements should not be limited by these terms. These terms are only used to distinguish one element from another element. Thus, a 1^{st} element discussed below could be termed a 2^{nd} element without departing from the teachings of the disclosure.

As used herein, expressions such as "at least one of," when preceding a list of elements, modify the entire list of elements and do not modify the individual elements of the list. For example, the expression, "at least one of a, b and c," should be understood as including only a, only b, only c, both a and b, both a and c, both b and c, or all of a, b and c. Herein, when a term "same" is used to compare a dimension of two or more elements, the term may cover a "substantially same" dimension.

It will be also understood that, even if a certain step or operation of manufacturing an apparatus or structure is described later than another step or operation, the step or operation may be performed later than the other step or operation unless the other step or operation is described as being performed after the step or operation.

Many embodiments are described herein with reference to cross-sectional views that are schematic illustrations of the embodiments (and intermediate structures). As such, variations from the shapes of the illustrations as a result, for example, of manufacturing techniques and/or tolerances, are to be expected. Thus, the embodiments should not be construed as limited to the particular shapes of regions illustrated herein but are to include deviations in shapes that result, for example, from manufacturing. Various regions illustrated in the figures are schematic in nature and their shapes are not intended to illustrate the actual shape of a region of a device and are not intended to limit the scope of the disclosure. Further, in the drawings, the sizes and relative sizes of layers and regions may be exaggerated for clarity.

For the sake of brevity, conventional elements, structures or layers of semiconductor devices including a nanosheet transistor and materials forming the same may or may not be described in detail herein. For example, a certain isolation layer or structure of a semiconductor device and materials forming the same may be omitted herein when this layer or structure is not related to the novel features of the embodiments. Also, descriptions of materials forming well-known structural elements of a semiconductor device may be omitted herein when those materials are not relevant to the novel features of the embodiments. Herein, the term "isolation" pertains to electrical insulation or separation between structures, layers, components or regions in a corresponding device or structure.

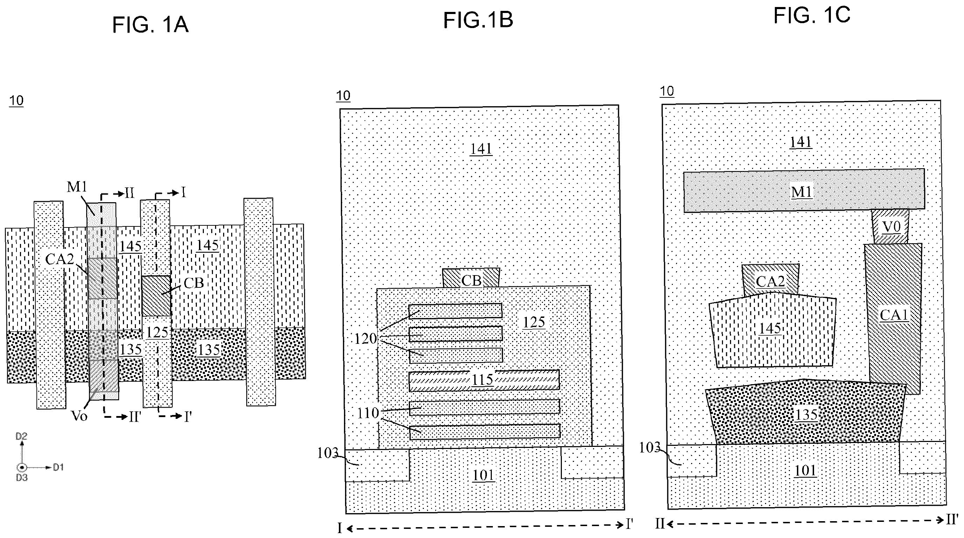

FIGS. 1A-1C illustrate a 3D-stacked semiconductor device in which a contact structure is formed on each of a source/drain region at a 1^{st} level and a source/drain region at a 2^{nd} level, according to one or more embodiments.

FIG. 1A is a plan view of a 3D-stacked semiconductor device 10, and FIGS. 1B and 1C are cross-section views of the 3D-stacked semiconductor device 10 shown in FIG. 1A taken along lines I-I' and II-II', respectively. It is to be understood here that FIG. 1A is provided to show a positional relationship between selected structural elements of the 3D-stacked semiconductor device 10, and thus, some structural elements such as a substrate 101 and an isolation structure 141 shown in FIGS. 1B and 1C are not shown in FIG. 1A.

As shown in FIG. 1A, a D1 direction is a channel-length direction in which a current flows between two source/drain regions connected to each other through a channel structure, a D2 direction is a channel-width direction that intersects the D1 direction, and a D3 direction is a vertical direction that intersects the D1 and D2 directions both of which are horizontal directions.

Referring to FIGS. 1A-1C, the 3D-stacked semiconductor device 10 may include a plurality of nanosheet layers forming a 1^{st} channel structure 110 at a 1^{st} level above a substrate 101, and a plurality of nanosheet layers forming a 2^{nd} channel structure 120 at a 2^{nd} level above the 1^{st} level. A middle isolation structure 115 may be formed between the 1^{st} channel structure 110 and the 2^{nd} channel structure 120. The nanosheet layers of the channel structures 110 and 120 may have been epitaxially grown from the substrate 101. The 1^{st} channel structure 110 may connect 1^{st} source/drain regions 135 to each other so that a current flows therebetween at a control of a gate structure 125 which surrounds the 1^{st} channel structure 110. Similarly, the 2^{nd} channel structure 120 may connect 2^{nd} source/drain regions 145 to each other so that a current flows therebetween at a control of the gate structure 125 which surrounds the 2^{nd} channel structure 120. The 1^{st} source/drain regions 135 may be epitaxially grown from the 1^{st} channel structure 110 and the 2^{nd} source/drain regions 145 may be epitaxially grown from the 2^{nd} channel structure 120.

Thus, in the 3D-stacked semiconductor device 10, the 1^{st} channel structure 110 along with the 1^{st} source/drain regions 135 and the gate structure 125 may form a 1^{st} transistor, which is a nanosheet transistor, at the 1^{st} level. Further, the 2^{nd} channel structure 120 along with the 2^{nd} source/drain regions 145 and the gate structure 125 may form a 2^{nd} transistor, which is also a nanosheet transistor, at the 2^{nd} level. Here, the gate structure 125, as an example, may be a common gate structure shared by the two transistors to form a complementary metal oxide semiconductor (CMOS) device structure such as an inverter circuit.

The substrate 101 may be a silicon (Si) substrate. Additionally or alternatively, it may include other materials such as silicon germanium (SiGe), silicon carbide (SiC), not being limited thereto. Each nanosheet layer forming the channel structures 110 and 120 may be formed of silicon (Si) or silicon germanium (SiGe). The 1^{st} source/drain regions 135 and the 2^{nd} source/drain regions 145 may also be formed of Si or SiGe. However, when the 1^{st} source/drain regions 135 are formed of Si and doped with n-type impurities such as phosphorus (P), arsenic (As), antimony (Sb), etc., the 1^{st} transistor may be an n-type transistor. In contrast, when the 2^{nd} source/drain regions 145 are formed of SiGe and doped with impurities such as boron (B), gallium (Ga), indium (In), etc., the 2^{nd} transistor may be a p-type transistor.

On an upper-left corner and an upper-right corner of the substrate 101 may be formed a shallow isolation trench (STI) structure 103, and an isolation structure 141 may be formed above the STI structure 103. The STI structure 103 and the isolation structure 141 may isolate the 3D-stacked semiconductor device 10 from another 3D-stacked semiconductor device or circuit element. The STI structure 103 and the isolation structure 141 may each be formed of silicon oxide (SiO, SiO₂, etc.). The middle isolation structure 115 may be formed of silicon nitride (e.g., SiN, SiBCN, SiCN, SiOCN, etc.).

The gate structure 125 may include a gate dielectric layer and a conductor layer. The gate dielectric layer may include a high-k material such as Hf, Al, Zr, La, Mg, Ba, Ti, Pb, and/or a combination thereof, not being limited thereto, and the conductor layer may include a metal or metal compound such as Cu, Al, Ti, Ta, W, Co, TiN, WN, TiAl, TiAlN, TaN, TiC, TaC, TiAlC, TaCN, TaSiN, or a combination thereof, not being limited thereto.

A gate contact structure CB may be formed on the gate structure 125 to receive a gate input signal through a metal line included in a back-end-of-line (BEOL) layer. A 1^{st} contact structure CA1 may be formed on the 1^{st} source/drain region 135, and a 2^{nd} contact structure CA2 may be formed on the 2^{nd} source/drain region 145. The 1^{st} and 2^{nd} contact structures CA1 and CA2 may connect the 1^{st} and 2^{nd} source/drain regions 135 and 145, respectively, to one or more voltage sources or another circuit element for internal signal routing through respective metal lines included in the BEOL layer. For example, FIG. 1C shows that the 1^{st} contact structure CA1 is connected to a metal line M1 through a via structure V0 in an M1 layer. Each of the contact structures CB, CA1 and CA2, the metal line M1, and the via structure V0 may be formed of a metal or metal compound such as Cu, W, Al, Ru, Mo, Co, and/or a combination thereof, not being limited thereto.

In the meantime, the 2^{nd} channel structure 120 may be formed to have a smaller width in the D2 direction than the 1^{st} channel structure 110. For example, while a left edge (or left side surface) of the 2^{nd} channel structure 120 is vertically aligned or coplanar with a left edge (or left side surface) of the 1^{st} channel structure 110, a right edge (or right side surface) of the 2^{nd} channel structure 120 is not vertically aligned or coplanar with a right edge (or right side surface) of the 1^{st} channel structure 110. Thus, a right side of the 2^{nd} channel structure 120 and above the 1^{st} channel structure 110 may provide a non-overlapping region where the 2^{nd} channel structure 120 does not vertically overlap the 1^{st} channel structure 110.

When the 2^{nd} channel structure 120 has the smaller width than the 1^{st} channel structure 110 in the D2 direction, the 2^{nd} source/drain region 145 epitaxially grown from the 2^{nd} channel structure 120 may also have a smaller width in the D2 direction than the 1^{st} source/drain region 135 epitaxially grown from the 1^{st} channel structure 110. For example, while a left edge of the 2^{nd} source/drain region 145 is vertically aligned or coplanar with a left edge of the 1^{st} source/drain region 135, a right edge of the 2^{nd} source/drain region 145 is not vertically aligned or coplanar with a right edge of the 1^{st} source/drain region 135. Thus, a right side of the 2^{nd} source/drain region 145 and above the 1^{st} source/drain region 135 may provide a non-overlapping region where the 2^{nd} source/drain region 145 does not vertically overlap the 1^{st} source/drain region 135.

The foregoing width differences between the source/drain regions are provided to form the 1^{st} contact structure CA1 to be extended straight down from the metal line M1 and the via structure V0 through the non-overlapping region above the 1^{st} source/drain region 135 and formed on at least a portion of a top surface of the 1^{st} source/drain region 135 in a limited area, as shown in FIG. 1C. Further, in order to avoid a possible short-circuit risk with the 2^{nd} source/drain region 145 and the 2^{nd} contact structure CA2, the 1^{st} contact structure CA1 may be formed to contact an upper-right edge portion of the 1^{st} source/drain region including an upper-right portion of the top surface thereof. In this case, however, a contact area between the 1^{st} source/drain region 135 and the 1^{st} contact structure may be reduced, which may result in increase of contact resistance between these two structures, thereby adversely affecting performance of the 3D-stacked semiconductor device 10 in terms of power delivery or signal routing.

Thus, the following embodiments are provided to address the reduced contact area between the 1^{st} source/drain region 135 and the 1^{st} contact structure.

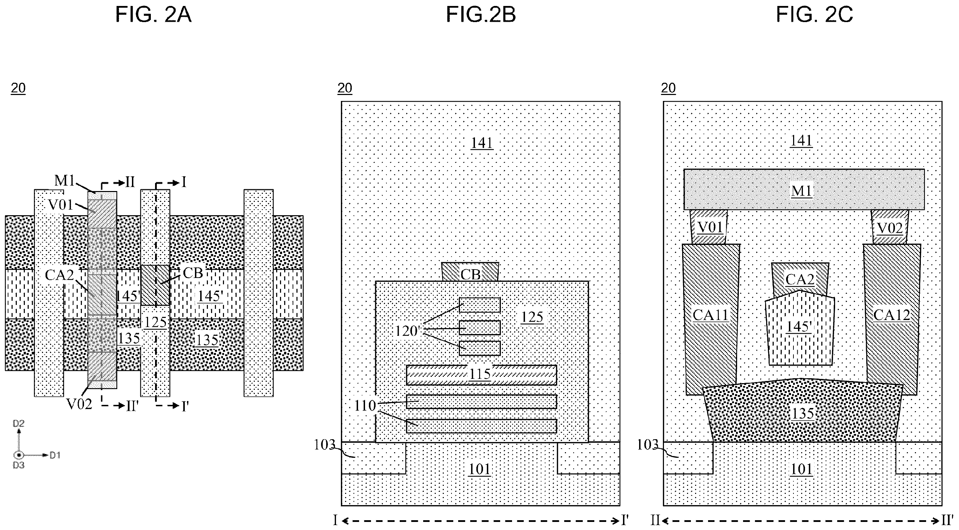

FIGS. 2A-2C illustrate a 3D-stacked semiconductor device in which two contact structures are formed on a source/drain region at a 1^{st} level and a contact structure is formed on a source/drain region at a 2^{nd} level, according to one or more embodiments.

FIG. 2A is a plan view of a 3D-stacked semiconductor device 20, and FIGS. 2B and 2C are cross-section views of the 3D-stacked semiconductor device 20 shown in FIG. 2A taken along lines I-I' and II-II', respectively. It is to be understood here that FIG. 2A is provided to show a positional relationship between selected structural elements of the 3D-stacked semiconductor device 20, and thus, some structural elements such as a substrate 101 and an isolation structure 141 shown in FIGS. 2B and 2C are not shown in FIG. 2A.

Referring to FIGS. 2A-2C, the 3D-stacked semiconductor device 20 has the same structural configuration as the 3D-stacked semiconductor device 10 of FIGS. 1A-1C except that the 3D-stacked semiconductor device 20 has a different 2^{nd} channel structure 120' and a different 2^{nd} source/drain region 145', and further, an additional 1^{st} contact structure CA11 and via structure V01. Thus, duplicate descriptions thereof may be omitted herein, and instead, different aspects of the 3D-stacked semiconductor device 20 are described below.

Like in the 3D-stacked semiconductor device 10, the 3D-stacked semiconductor device 20 may also have the 2^{nd} channel structure 120' of which a width in the D2 direction is smaller than that of the 1^{st} channel structure 110. However, the 2^{nd} channel structure 120' of the 3D-stacked semiconductor device 20 may have a smaller width than the 2^{nd} channel structure 120 of the 3D-stacked semiconductor device 10. For example, unlike the 2^{nd} channel structure 120, the 2^{nd} channel structure 120' may be formed such that both a left edge (or left side surface) and a right edge (or right side surface) of the 2^{nd} channel structure 120' are not vertically aligned or coplanar with a left edge (or left side surface) and a right edge (or right side surface) of the 1^{st} channel structure 110, respectively. Thus, both sides of the 2^{nd} channel structure 120 and above the 1^{st} channel structure 110 may provide respective non-overlapping regions where the 2^{nd} channel structure 120 does not vertically overlap the 1^{st} channel structure 110.

Accordingly, the 2^{nd} source/drain region 145' may be formed to have a smaller width than the 2^{nd} source/drain region 145 of the 3D-stacked semiconductor device 10 such that a left edge (or left side surface) and a right edge (or right side surface) of the 2^{nd} source/drain region 145' are not vertically aligned or coplanar with a left edge (or left side surface) and a right edge (or right side surface) of the 1^{st} source/drain region 135, respectively. Thus, both sides of the 2^{nd} source/drain region 145' and above the 1^{st} source/drain region 135 may provide respective non-overlapping regions where the 2^{nd} source/drain region 145' does not vertically overlap the 1^{st} source/drain region 135.

Taking advantage of the non-overlapping regions formed at both sides of the 2^{nd} source/drain region 145' and above the 1^{st} source/drain region 135 therebelow, two 1^{st} contact structures CA11 and CA12 may be formed to connect an upper-left edge portion and an upper-right edge portion of the 1^{st} source/drain region 135 to a metal line M1 through via structures V01 and V02 in the M1 layer, respectively. For example, each of the 1^{st} contact structures CA11 and CA12 respectively formed on the upper-left edge portion and the upper-right edge portion may pass through a non-overlapping region to be connected to the metal line M1. The upper-left edge portion and the upper-right edge portion of the 1^{st} source/drain region 135 includes an upper-left portion and the upper-right portion of the top surface of the 1^{st} source/drain region 135. Further, the upper-left edge portion and the upper-right edge portion of the 1^{st} source/drain region 135 may include an upper-left side surface and the upper-right side surface of the 1^{st} source/drain region 135, as shown in FIG. 2C. The M1 layer may be included in a BEOL layer of the 3D-stacked semiconductor device 20.

The two 1^{st} contact structures CA11 and CA12 may be connected through the metal line M1 so that the 1^{st} source/drain region 135 may be connected to a voltage source or another circuit element through two contact structures CA11 and CA12 to overcome reduction of a contact area and increase of contact resistance.

Each of the contact structures CA11 and CA12, the metal line M1, and the via structures V01 and V02 may be formed of a metal or metal compound such as Cu, W, Al, Ru, Mo, Co, and/or a combination thereof, not being limited thereto.

FIGS. 2A-2C show that two contact structures CA11 and CA12 are formed at two opposite sides of the 2^{nd} source/drain region 145', that is, two non-overlapping regions. However, the disclosure may not be limited thereto, and two or more contact structures may be formed through at least one of the two opposite sides of the 2^{nd} source/drain region 145', according to one or more other embodiments. Further, only one of the two contact structures CA11 and CA12 may be formed on a corresponding side of the 2^{nd} source/drain region 145' when routing congestion is expected on the other side of the 2^{nd} source/drain region 145' by another connection or contact structure. In addition, according to one or more embodiments, while only one 2^{nd} contact structure CA2 is formed on the 2^{nd} source/drain region 145', two or more 1^{st} contact structures including CA 11 and CA12 may be formed on the 1^{st} source/drain region 135, wherein at least two of the 1^{st} contact structures may be connected to each other.

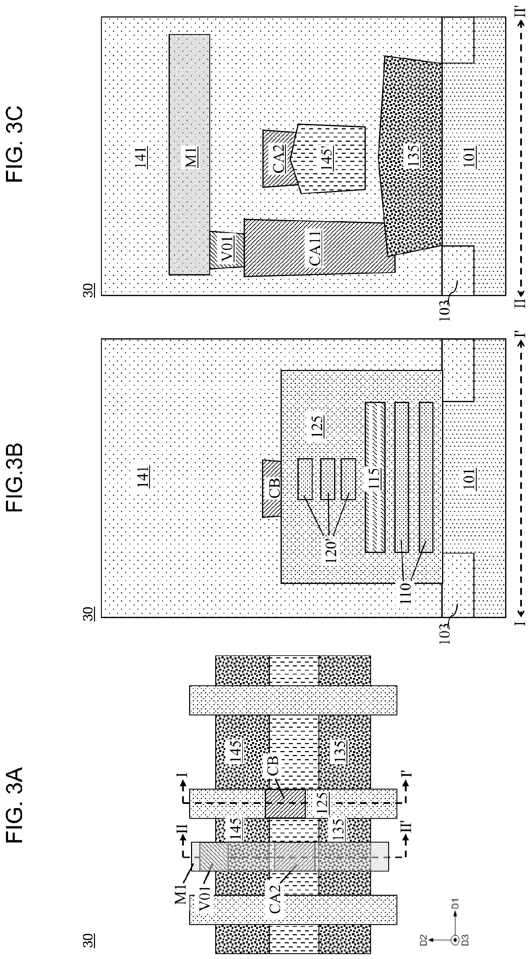

FIGS. 3A-3C illustrate a 3D-stacked semiconductor device in which only one of two contact structures of the 3D-stacked semiconductor device shown in FIGS. 2A-2C is formed on a source/drain region at a 1^{st} level and a contact structure is formed on a source/drain region at a 2^{nd} level, according to one or more embodiments.

FIG. 3A is a plan view of a 3D-stacked semiconductor device 30, and FIGS. 3B and 3C are cross-section views of the 3D-stacked semiconductor device 30 shown in FIG. 3A taken along lines I-I' and II-II', respectively. It is to be understood here that FIG. 3A is provided to show a positional relationship between selected structural elements of the 3D-stacked semiconductor device 30, and thus, some structural elements such as a substrate 101 and an isolation structure 141 shown in FIGS. 3B and 3C are not shown in FIG. 3A.

Referring to FIGS. 3A-3C, the 3D-stacked semiconductor device 30 has the same structural configuration as the 3D-stacked semiconductor device 20 of FIGS. 2A-2C except that, in the 3D-stacked semiconductor device 30, the 1^{st} contact structure CA12 and the via structures V02 of the 3D-stacked semiconductor device 20 are removed. Thus, duplicate descriptions thereof may be omitted herein, and instead, different aspects of the 3D-stacked semiconductor device 30 are described below.

The 3D-stacked semiconductor device 30 may be formed by removing, from the 3D-stacked semiconductor device 20 of FIGS. 2A-2C, the 1^{st} contact structure CA12 formed on the upper-right edge portion of the 1^{st} source/drain region 135 and the via structure V02 formed on the 1^{st} contact structure CA12. These two structures may be removed, for example, when routing congestion is expected at the right side of the 2^{nd} source/drain region 145' and above the top surface of the 1^{st} source/drain region 135, that is, a non-overlapping region. For example, when an another connection structure or contact structure is routed through this non-overlapping region, the 3D-stacked semiconductor device 30 may be configured to forgo the 1^{st} contact structure CA12.

Thus, the 3D-stacked semiconductor device 30 may provide an additional space, that is, a non-overlapping region wherein another circuit element other than the 1^{st} contact structure CA11 can be formed, thereby increasing device density and a degree of freedom in a circuit design including the 3D-stacked semiconductor device 30.

The design flexibility of a 3D-stacked semiconductor device in which a non-overlapping region is provided at each side of a 2^{nd} source/drain region at a 2^{nd} level as described above may be applied to various different embodiments as described below.

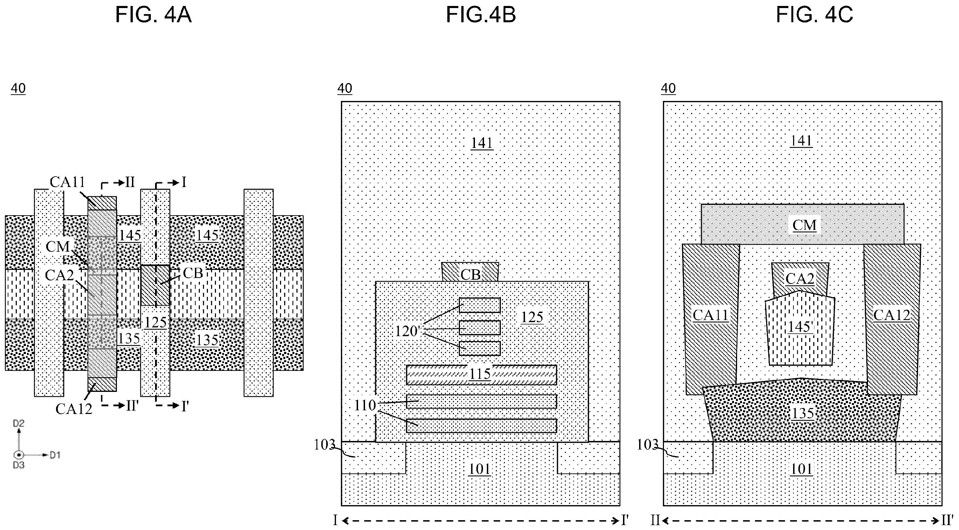

FIGS. 4A-4C illustrate a 3D-stacked semiconductor device in which two contact structures are formed on a source/drain region at a 1^{st} level and a contact structure is formed on a source/drain region at a 2^{nd} level, according to one or more other embodiments.

FIG. 4A is a plan view of a 3D-stacked semiconductor device 40, and FIGS. 4B and 4C are cross-section views of the 3D-stacked semiconductor device 40 shown in FIG. 4A taken along lines I-I' and II-II', respectively. It is to be understood here that FIG. 4A is provided to show a positional relationship between selected structural elements of the 3D-stacked semiconductor device 40, and thus, some structural elements such as a substrate 101 and an isolation structure 141 shown in FIGS. 4B and 4C are not shown in FIG. 4A.

Referring to FIGS. 4A-4C, the 3D-stacked semiconductor device 40 has the same structural configuration as the 3D-stacked semiconductor device 20 of FIGS. 2A-2C except that the 3D-stacked semiconductor device 40 includes another contact structure CM. Thus, duplicate descriptions thereof may be omitted herein, and instead, different aspects of the 3D-stacked semiconductor device 40 are described below.

Compared to the 3D-stacked semiconductor device 20 of FIGS. 2A-2C in which the two 1^{st} contact structures CA11 and CA12 are connected through the metal line M1 and the via structures V01 and V02 in the BEOL layer, the 3D-stacked semiconductor device 40 may have the two 1^{st} contact structures CA11 and CA12 connected through another contact structure CM, which is a structural element formed in a middle-of-line (MOL) process of manufacturing the 3D-stacked semiconductor device 40. In other words, in the 3D-stacked semiconductor device 40, the two 1^{st} contact structures CA11 and CA12, which are MOL structures, may be connected by another MOL structure in an MOL layer below the BEOL layer. Unlike the metal line M1 in the BEOL layer, no via structures such as the via structure V01 and V02 are formed to connect the 1^{st} contact structures CA11 and CA12 to the contact structure CM.

This contact structure CM of the MOL layer may be formed when routing congestion is expected in a BEOL layer above the 2^{nd} source/drain region 145' of the 3D-stacked semiconductor device 40. For example, a circuit design including the 3D-stacked semiconductor device 40 may not allow formation of the metal line M1 and the via structures V01 and V02 to connect the two 1^{st} contact structures CA11 and CA12 included in the 3D-stacked semiconductor device 20. Thus, another MOL structure such as the contact structure CM may be formed to connect the two 1^{st} contact structures CA11 and CA12 so that the 3D-stacked semiconductor device 40 may overcome the reduction of contact area and the increase of contact resistance.

The contact structure CM may be a metal line formed in an MOL layer, and include the same or similar material such as Cu, W, Al, Ru, Mo, Co, and/or a combination thereof forming the contact structures CA11, CA12, CA2, CB, the via structures V01, V02 and the metal line M1.

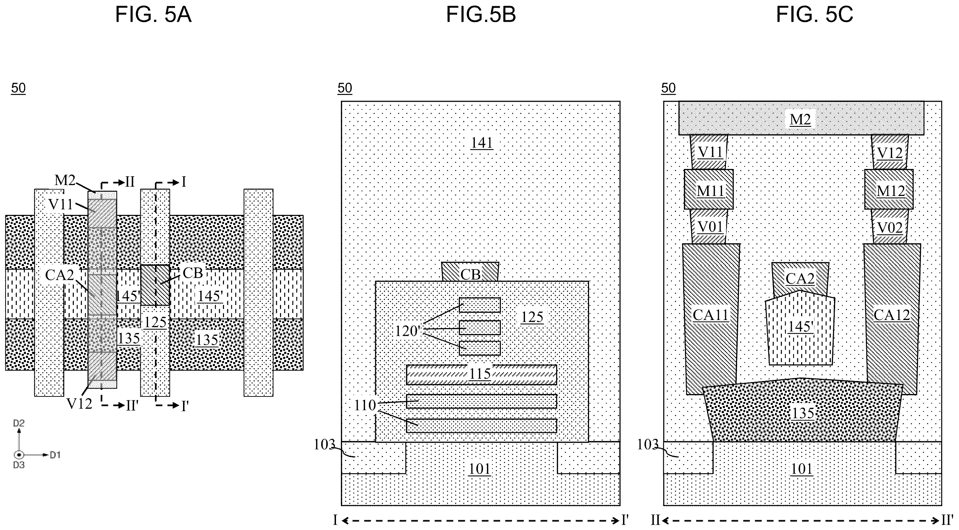

FIGS. 5A-5C illustrate a 3D-stacked semiconductor device in which two contact structures are formed on a source/drain region at a 1^{st} level and a contact structure is formed on a source/drain region at a 2^{nd} level, according to one or more other embodiments.

FIG. 5A is a plan view of a 3D-stacked semiconductor device 50, and FIGS. 5B and 5C are cross-section views of the 3D-stacked semiconductor device 50 shown in FIG. 5A taken along lines I-I' and II-II', respectively. It is to be understood here that FIG. 5A is provided to show a positional relationship between selected structural elements of the 3D-stacked semiconductor device 50, and thus, some structural elements such as a substrate 101 and an isolation structure 141 shown in FIGS. 5B and 5C are not shown in FIG. 5A.

Referring to FIGS. 5A-5C, the 3D-stacked semiconductor device 50 has the same structural configuration as the 3D-stacked semiconductor device 20 of FIGS. 2A-2C except that the 3D-stacked semiconductor device 50 includes additional BEOL structures. Thus, duplicate descriptions thereof may be omitted herein, and instead, different aspects of the 3D-stacked semiconductor device 50 are described below.

Compared to the 3D-stacked semiconductor device 20 of FIGS. 2A-2C in which the two 1^{st} contact structures CA11 and CA12 connected through the metal line M1 and the via structures V01 and V02 in the M1 layer, the 3D-stacked semiconductor device 50 may have the two 1^{st} contact structures CA11 and CA12 connected in an M2 layer above the M1 layer. For example, the 1^{st} contact structure CA11 may be connected to an M2 metal line in the M2 layer through the via structure V01 and the metal line M11 in the M1 layer and the via structure V11 in the M2 layer. Similarly, the 1^{st} contact structure CA12 may be connected to the M2 metal line in the M2 layer through the via structure V02 and the metal line M12 in the M1 layer and the via structure V12 in the M2 layer. The M1 layer and M2 layer may both be formed in a BEOL process of manufacturing the 3D-stacked semiconductor device 50, and thus, may be included in the BEOL layer.

This connection of the two 1^{st} contact structures CA11 and CA12 through the M2 metal line in the M2 layer may also be configured when routing congestion is expected in the MOL layer and a lower BEOL layer, that is, the M1 layer, above the 2^{nd} source/drain region 145' of the 3D-stacked semiconductor device 50. Still, however, the 3D-stacked semiconductor device 50 may also overcome the reduction of contact area and the increase of contact resistance that may occur in the 3D-stacked semiconductor device 10 shown in FIGS. 1A-1C.

Each of the contact structures CA11 and CA12, the metal lines M11, M12, M2 and the via structures V01, V02, V11 and V12 may be formed of a metal or metal compound such as Cu, W, Al, Ru, Mo, Co, and/or a combination thereof, not being limited thereto.

In the above embodiments, the 1^{st} transistor at the 1^{st} level and the 2^{nd} transistor at the 2^{nd} level of each of the 3D-stacked semiconductor devices 10-50 are all described as a nanosheet transistor. However, the disclosure may not be limited thereto. According to one or more embodiments, at least one of the 1^{st} transistor and the 2^{nd} transistor may be a different type of transistor such as FinFET, forksheet transistor, etc..

Further, in the 3D-stacked semiconductor devices 20, 40 and 50, the two contact structures CA11 and CA12 are formed on the 1^{st} source/drain region of the 1^{st} transistor at the 1^{st} level. However, according to one or more other embodiments, multiple contact structures may also be formed on a source/drain region of a single-stack semiconductor device depending on a circuit design considering routing congestion of the semiconductor device.

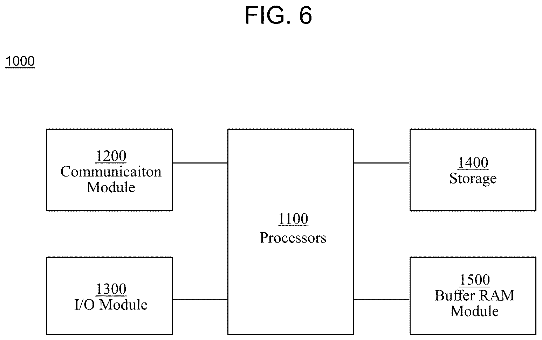

FIG. 6 is a schematic block diagram illustrating an electronic device including a semiconductor device in which two or more contact structures are formed on a source/drain region of the semiconductor device, according to one or more embodiments. This semiconductor device may be one of the 3D-stacked semiconductor devices 20-50 shown in FIGS. 1A-1C to 5A-5C, according to one or more embodiments.

Referring to FIG. 6, an electronic device 1000 may include at least one processor 1100, a communication module 1200, an input/output module 1300, a storage 1400, and a buffer random access memory (RAM) module 1500. The electronic device 1000 may be a mobile device such as a smartphone or a tablet computer, not being limited thereto, according to embodiments.

The processor 1100 may include a central processing unit (CPU), a graphic processing unit (GPU) and/or any other processors that control operations of the electronic device 1000. The communication module 1200 may be implemented to perform wireless or wire communications with an external device. The input/output module 1300 may include at least one of a touch sensor, a touch panel a key board, a mouse, a proximate sensor, a microphone, etc. to receive an input, and at least one of a display, a speaker, etc. to generate an output signal processed by the processor 1100. The storage 1400 may be implemented to store user data input through the input/output module 1300, the output signal, etc. The storage 1400 may be an embedded multimedia card (eMMC), a solid state drive (SSD), a universal flash storage (UFS) device, etc.

The buffer RAM module 1500 may temporarily store data used for processing operations of the electronic device 1000. For example, the buffer RAM 1500 may include a volatile memory such as double data rate (DDR) synchronous dynamic random access memory (SDRAM), low power double data rate (LPDDR) SDRAM, graphics double data rate (GDDR) SDRAM, Rambus dynamic random access memory (RDRAM), etc.

Although not shown in FIG. 6, the electronic device 1000 may further include at least one sensor such as an image sensor.

At least one component in the electronic device 1000 may be formed based on a semiconductor device (10-50) in which two or more contact structures are formed on a source/drain region of the semiconductor device (10-50), according to one or more embodiments.

## Claims

1. A semiconductor device (20, 40, 50) comprising:
a 1^{st} source/drain region (135); and
a 1^{st} contact structure (CA11) on a 1^{st} portion of the 1^{st} source/drain region (135); and
a 2^{nd} contact structure (CA12) on a 2^{nd} portion of the 1^{st} source/drain region (135),
wherein at least one of the 1^{st} contact structure (CA11) and the 2^{nd} contact structure (CA12) is configured to connect the 1^{st} source/drain region (135) to a voltage source or another circuit element for signal routing.

2. The semiconductor device (20, 40, 50) of claim 1, wherein the 1^{st} contact structure (CA11) and the 2^{nd} contact structure (CA12) are connected.

3. The semiconductor device (20, 40, 50) of claim 1 or 2, further comprising a metal line (M1, CM) above the 1^{st} source/drain region (145),
wherein the 1^{st} contact structure (CA11) and the 2^{nd} contact structure (CA12) are connected through the metal line (M1).

4. The semiconductor device (20, 50) of claim 3, further comprising a 1^{st} via structure (V01) and a 2^{nd} via structure (V02) respectively formed on the 1^{st} contact structure (CA11) and the 2^{nd} contact structure (CA12),
wherein the 1^{st} via structure (V01) and the 2^{nd} via structure (V02) are connected to the metal line (M1).

5. The semiconductor device (40) of claim 3, no via structure is formed between each of the 1^{st} contact structure (CA11) and the 2^{nd} contact structure (CA12) and the metal line (CM).

6. The semiconductor device (20, 40, 50) of any one of claims 1 to 5, further comprising a 2^{nd} source/drain region (145) vertically above the 1^{st} source/drain region (135),
wherein the 2^{nd} source/drain region (145) has a smaller width than the 1^{st} source/drain region (135),
wherein, at each of two opposite sides of the 2^{nd} source/drain region (145), a non-overlapping region where the 2^{nd} source/drain region (145) does not vertically overlap the 1^{st} source/drain region (135) is formed, and
wherein at least one of the 1^{st} contact structure (CA11) and the 2^{nd} contact structure (CA12) is formed to pass through the non-overlapping region to be connected to the 1^{st} source/drain region (135).

7. The semiconductor device (20, 40, 50) of claim 6, wherein the 1^{st} contact structure (CA11) and the 2^{nd} contact structure (CA2) are formed to pass through the respective non-overlapping regions to be connected to the 1^{st} source/drain region (135).

8. The semiconductor device (20, 40, 50) of any one of claims 1 to 7, wherein the 1^{st} portion is an upper-left edge portion of the 1^{st} source/drain region (135), and the 2^{nd} portion is an upper-right edge portion of the 1^{st} source/drain region (135).

9. A semiconductor device (10-50) comprising:
a 1^{st} source/drain region (135) for a 1^{st} transistor; and
a 2^{nd} source/drain region (145) for a 2^{nd} transistor, the 2^{nd} source/drain region (145) being disposed vertically above the 1^{st} source/drain region (135),
wherein the 2^{nd} source/drain region (145) has a smaller width than the 1^{st} source/drain region (135) in a channel-width direction view, the channel-width direction (D2) intersects a direction of current flow in each of the 1^{st} transistor and the 2^{nd} transistor, and
wherein a non-overlapping region, where the 2^{nd} source/drain region (145) does not vertically overlap the 1^{st} source/drain region (135), is formed at each of a left side and a right side of the 2^{nd} source/drain region (145) in the channel-width direction view.

10. The semiconductor device (20, 40, 50) of claim 9, further comprising:
a 1^{st} contact structure (CA1) on the 1^{st} source/drain region (135), wherein the 1^{st} contact structure (CA1) passes through one of the non-overlapping regions; and/or
a 2^{nd} contact structure (CA12) on the 1^{st} source/drain region (135),
wherein the 2^{nd} contact structure (CA12) passes through the other of the non-overlapping regions.

11. The semiconductor device (20, 40, 50) of claim 10, further comprising a metal line (M1) above the 2^{nd} source/drain region (145),
wherein the 1^{st} contact structure (CA1) and the 2^{nd} contact structure (CA12) are connected through the metal line (M1).

12. The semiconductor device (20, 40, 50) of claim 10 or 11, wherein the 1^{st} contact structure (CA1) is formed on an upper-left edge portion of the 1^{st} source/drain region (135), and/or wherein the 2^{nd} contact structure (CA12) is formed on an upper-right edge portion of the 1^{st} source/drain region (135).

13. A semiconductor device (20, 40, 50) comprising:
a 1^{st} source/drain region (135); and
a 2^{nd} source/drain region (145), vertically above the 1^{st} source/drain region (135),
wherein two or more 1^{st} contact structures (CA11, CA12) are formed on the 1^{st} source/drain region (135), and
wherein only one 2^{nd} contact structure (CA2) is formed on the 2^{nd} source/drain region (145).

14. The semiconductor device (20, 40, 50) of claim 13, wherein at least one of the two or more 1^{st} contact structures (CA11, CA12) is formed at a side of the 2^{nd} source/drain region (145) on a top surface of the 1^{st} source/drain region (135).

15. The semiconductor device (20, 40, 50) of claim 14, wherein at least two of the two or more 1^{st} contact structures (CA11, CA12) are connected to each other, preferably through a metal line (M1) in a middle-of-line (MOL) layer or a back-end-of-line, BEOL, layer.
